# EUROPEAN PATENT APPLICATION

(11) **EP 4 847 156 A1**
(43) Date of publication of application: **02.12.2026**
(21) Application number: 25224706.9
(22) Date of filing: 17.12.2025
(51) Int. Cl.: B21B 13/14

(54) **CROWN DESIGN METHOD OF CYLINDRICAL ROLLER FOR BACKING BEARING IN MULTI-ROLL MILL**

(30) Priority: 29.05.2025 CN 202510709350
(71) Applicant: C&U Company Limited., Wenzhou, Zhejiang Province (CN); Shanghai C&U Group Co., Ltd., Shanghai (CN); Huangshi C&U Bearing Co., Ltd., Huangshi City (CN)
(72) Inventor: BAI, Xuefeng, Shanghai (CN); LIU, Lizhao, Shanghai (CN); JIN, Linjun, Shanghai (CN); XU, Jialiang, Shanghai (CN); CHEN, Siqian, Shanghai (CN)
(74) Representative: Chung, Hoi Kan

(57) **Abstract**

The present disclosure discloses a crown design method for a cylindrical roller for a backing bearing in a multi-roll mill, wherein the crown design method comprises the following design processes: S1, establishing a roller crown design equation based on a conventional equation; S2, calculating an edge crown numerical value; S3, solving a crown profile curve. By improving a shape of a roller crown curve, the present disclosure achieves a balance between the suppression of stress concentration at heavy loads and the improvement of rotational accuracy at light loads, solves problems that when the cylindrical roller for the backing bearing of the multi-roll mill adopts a logarithmic crown design, the crown design under high load conditions is large, it's difficult to improve the rotational accuracy, it's not possible to compromise the suppression of edge stress concentration at heavy loads with the improvement of the service life of bearings at light loads.

## Description

### TECHNICAL FIELD

The present disclosure relates to the technical field of bearing machining, and specifically relates to a crown design method for a cylindrical roller for a backing bearing in a multi-roll mill for optimizing roller surface profiles to improve the bearing capacity and rotational accuracy of the bearing.

### BACKGROUND

Multi-roll cold rolling mills are important in the production of metal strips such as stainless steel and silicon steel, as key components of backup rolls, backing bearings of the multi-roll cold rolling mills require to meet double requirements for high accuracy and high bearing capacity, conventional roller bearings often adopt a logarithmic crown design to avoid edge stress concentration, but the design has the following significant defects under high load conditions: 1, a logarithmic crown curve is complicated, the machining difficulty is large, and the straightness of middle segments of rollers is difficult to be guaranteed, resulting in increased runout errors when the bearings rotate; and 2, the problem of edge stress concentration at heavy loads is relieved, but the service life of the bearings is not significantly improved under light load conditions. As a result, conventional designs cannot meet the performance requirements of backing bearings under the composite conditions of "high-accuracy machining + heavy-load rolling", and there is an urgent need to optimize a crown curve design.

### SUMMARY

To address deficiencies in the prior art, the present disclosure provides a crown design method for a cylindrical roller for a backing bearing in a multi-roll mill, in order to solve the problems in the prior art that when the cylindrical roller for the backing bearing in the multi-roll rolling mill adopts a logarithmic crown design, the crown design under high load conditions is large, it is difficult to improve the rotational accuracy, and it is not possible to compromise the suppression of edge stress concentration at heavy loads with the improvement of the service life of bearings at light loads.

In order to achieve the above objects, the present disclosure provides a crown design method for a cylindrical roller for a backing bearing in a multi-roll mill, where the crown design method includes the following design processes:
S1, establishing a roller crown design equation based on a conventional equation: Ph=1.0115*a*f(x), where in the equation, a is a crown numerical value of a roller profile edge, f(x) is a dimensionless crown profile curve, and Ph is a roller crown value;
S2, calculating an edge crown numerical value: calculating the crown numerical value of the roller profile edge according to an equation a=4*Phl, where Phl=k0*Q/lwe*(1.1935+ln(lwe/2b)), where in the equation, k0 is a material correlation coefficient, Q is a maximum roller load, Lwe is a roller length, where b=(2*k0 Q/R/Lwe)^0.5, in an equation R=2*Dwp/(Dwp-Dwe)/Dwe, where Dwp is a bearing center diameter, and Dwe is a roller diameter; and
S3, solving the crown profile curve: calculating the f (x) crown profile curve according to the equation f(x)=e^(-(x-lwe/1.94595/0.112593/lwe)^2), where in the equation, x is a ratio of a distance from a point on a roller profile line to a midpoint of a roller to an effective length of the roller.

It is beneficial to adopt the above technical solution that: the edge crown numerical value a derived by an equation chain in the above technique and a profile curve f(x) form a composite shape of "middle segment nearly a straight line + two sides showing an exponential decline", such that edge stress of the roller rapidly delays at heavy loads, avoiding the problem of edge stress concentration of a traditional logarithmic crown; meanwhile, a convex of the middle segment is nearly a straight line, thereby being easy to machine and guaranteeing the running accuracy; and convex on two sides are reduced faster, guaranteeing that edge stress concentration does not occur at heavy loads, the entire curve is smoothly connected, and the service life is longer at the smooth running light loads.

The present disclosure is further arranged: based on step S2, the Q is a maximum roller load calculated under 0.3 Cr-0.5 Cr, where Cr is a rated dynamic load of the backing bearing.

It is beneficial to adopt the above technical solution that: in the above technique, this load range covers a typical working interval of the backing bearing, a crown value a calculated by the equation can exactly match an actual load, avoiding loss of rotational accuracy caused by an excessive crown or excessive edge stress caused by an insufficient crown; and meanwhile, exponential decay characteristics on both sides of a crown curve can effectively reduce edge micro-slip damage at light loads, and combined with low friction characteristics of a straight line profile in the middle segment, the service life of the bearing at light loads is improved over conventional logarithmic crown designs.

The present disclosure is further arranged: based on step S3, the x needs to satisfy the following condition: 0≤x≤0.5lwe.

It is beneficial to adopt the above technical solution that: in the above technique, a profile calculation range is limited within a one-sided half-length of the effective length of the roller, ensuring that the crown curve is symmetrical about the center of the roller, and avoiding unbalance load risks caused by an asymmetrical design; and meanwhile, a curve shape is decoupled from an actual length of the roller by a dimensionless method of x, thereby being suitable for designs of rollers of backing bearings in different specifications and dimensions.

### BRIEF DESCRIPTION OF THE DRAWINGS

FIG. 1 is a schematic diagram of a profile shape of a roller designed according to a Lundberg formula and a method of the present disclosure; and
FIG. 2 is a schematic diagram of contact stress of the roller designed according to the Lundberg formula and the method of the present disclosure at 0.05 Cr load.

### DETAILED DESCRIPTION OF THE EMBODIMENTS

The present disclosure provides a crown design method for a cylindrical roller for a backing bearing in a multi-roll mill, where the crown design method includes the following design processes:
S1, establishing a roller crown design equation based on a conventional equation: Ph=1.0115*a*f(x), where in the equation, a is a crown numerical value of a roller profile edge, f(x) is a dimensionless crown profile curve, and Ph is a roller crown value;
S2, calculating an edge crown numerical value: calculating the crown numerical value of the roller profile edge according to an equation a=4*Phl, where Phl=k0*Q/lwe*(1.1935+ln(lwe/2b)), where in the equation, k0 is a material correlation coefficient, where k0=2.81*10^-6mm2/N, Q is a maximum roller load, Lwe is a roller length, where b=(2*k0 Q/R/Lwe)^0.5, in an equation R=2*Dwp/(Dwp-Dwe)/Dwe, where Dwp is a bearing center diameter, and Dwe is a roller diameter; and
S3, solving the crown profile curve: calculating the f (x) crown profile curve according to the equation f(x)=e^(-(x-lwe/1.94595/0.112593/lwe)^2), where in the equation, x is a ratio of a distance from a point on a roller profile line to a midpoint of a roller to an effective length of the roller.

Further, based on step S2, the Q is a maximum roller load calculated at 0.3 Cr-0.5 Cr, where Cr is a rated dynamic load of the backing bearing.

Further, based on step S3, the x needs to satisfy the following condition: 0≤x≤0.5lwe.

Specific embodiment: a backing bearing is selected, with backing bearing parameters: rated dynamic load Cr of 1740 kN. The roller diameter Dwe is 29.5 mm, the roller length Lwe is 52 mm, and a chamfer of the roller is 0.8 mm.

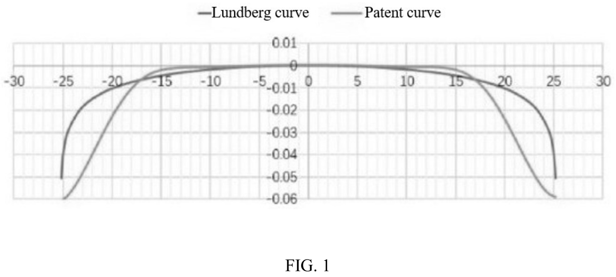

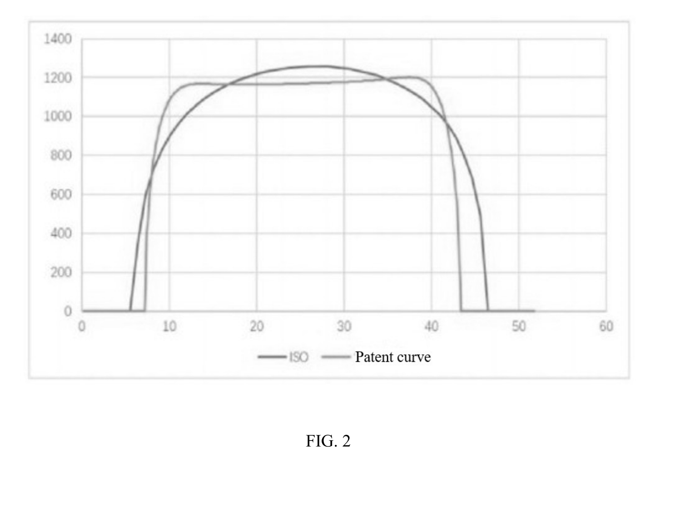

The above data is adopted, a shape of the roller profile calculated by substituting 0.05Cr into the above equation is as shown in FIG. 1, and analog simulation is performed on the roller profile in commercial software to calculate contact stress, as shown in FIG. 2, respectively.

It was found by comparison that the shape of the roller profile provided by the design method of the present disclosure is different from a profile curve obtained by using the Lundberg formula in linear segments and edge arc segments on both sides, under an applied load of 0.05Cr, the contact stress distribution of the middle segment calculated according to the formula of the present disclosure is more even, the length is longer, and the maximum stress is smaller, thereby extending the service life of the bearing. At the same time, it has been tried that the middle segment of the profile of the cylindrical roller using the equation according to the present disclosure is almost a straight line, making it easier to machine with high accuracy, the backing bearing using this type of roller can have a rotational accuracy of more than P4, and a high runout of a cross section reaches less than 2 µm.

The basic principles and main features of the present disclosure and the advantages of the present disclosure are shown and described above, those skilled in the art will appreciate that the present disclosure is not limited by the above-mentioned embodiments, the above-mentioned embodiments and the descriptions in the specification merely illustrate the principle of the present disclosure, without departing from the spirit and scope of the present disclosure, various changes and improvements can be made to the present disclosure, all such changes and improvements fall within the scope of protection of the claimed present disclosure, and the scope of protection of the claimed present disclosure is defined by the appended claims and their equivalents.

## Claims

1. A crown design method for a cylindrical roller for a backing bearing in a multi-roll mill, wherein the method comprises the following design processes:
S1, establishing a roller crown design equation based on a conventional equation: Ph=1.0115*a*f(x), where in the equation, a is a crown numerical value of a roller profile edge, f(x) is a dimensionless crown profile curve, and Ph is a roller crown value;
S2, calculating an edge crown numerical value: calculating the crown numerical value of the roller profile edge according to an equation a=4*Phl, wherein Phl=k0*Q*(1.1935+ln(lwe/2b))/lwe, wherein in the equation, k0 is a material correlation coefficient, Q is a maximum roller load, Lwe is a roller length, wherein b=(2*k0*(Q/R/Lwe))^0.5, in an equation R=2*Dwp/((Dwp-Dwe)*Dwe), wherein Dwp is a bearing center diameter, and Dwe is a roller diameter; and
S3, solving the crown profile curve: calculating the f (x) crown profile curve according to the equation f(x)=e^(-(((|x|-lwe/1.94595)/0.112593/lwe)^2)), wherein in the equation, x is a ratio of a distance from a point on a roller profile line to a midpoint of a roller to an effective length of the roller.

2. The crown design method for a cylindrical roller for a backing bearing in a multi-roll mill according to claim 1, wherein based on step S2, the Q is a maximum roller load calculated at 0.3 Cr-0.5 Cr, wherein Cr is a rated dynamic load of the backing bearing.

3. The crown design method for a cylindrical roller for a backing bearing in a multi-roll mill according to claim 1, wherein based on step S3, the x needs to satisfy the following condition: 0≤x≤0.5lwe.
